# EUROPÄISCHE PATENTSCHRIFT

(11) **EP 1 872 386 B1**
(45) Veröffentlichungstag und Bekanntmachung des Hinweises auf die Patenterteilung: **15.09.2010**
(21) Anmeldenummer: 06707647.1
(22) Anmeldetag: 28.03.2006
(51) Int. Cl.: H01L 21/00

(54) **EINRICHTUNG UND VERFAHREN ZUM AUFBRINGEN EINER GLEICHMÄSSIGEN, DÜNNEN FLÜSSIGKEITSSCHICHT AUF SUBSTRATE**
DEVICE AND METHOD FOR APPLICATION OF AN EVEN THIN FLUID LAYER TO SUBSTRATES
DISPOSITIF ET PROCEDE POUR APPLIQUER UNE COUCHE DE LIQUIDE MINCE ET HOMOGENE SUR DES SUBSTRATS

(30) Priorität: 22.04.2005 DE 102005019686
(43) Veröffentlichungstag der Anmeldung: 02.01.2008
(73) Patentinhaber: Schmid Technology Systems GmbH, 78078 Niedereschach (DE)
(72) Erfinder: BUCHNER, Christian, 69151 Neckargmünd (DE); BRUNNER, Johann, 75217 Birkenfeld (DE); KALMBACH, Helmut, 72250 Freudenstadt (DE); GENTISCHER, Josef, 71384 Weinstadt (DE)
(74) Vertreter: Dreiss
(86) Internationale Anmeldenummer: PCT/EP2006/002797
(87) Internationale Veröffentlichungsnummer: WO 2006/111247

(56) Entgegenhaltungen:
- WO-A-93/16812
- DE-B3-102005 019 686
- US-A1- 2003 039 766

## Beschreibung

Die vorliegende Erfindung bezieht sich auf eine Einrichtung zum Aufbringen einer gleichmäßigen, dünnen Flüssigkeits-, insbesondere Phosphorsäureschicht auf Substrate, insbesondere Siliziumzellen für die Fotovoltaik nach dem Oberbegriff des Anspruchs 1 sowie auf ein Verfahren zum Aufbringen einer gleichmäßigen, dünnen Flüssigkeitsinsbesondere Phosphorsäureschicht auf Substrate, insbesondere Siliziumzellen, für die Fotovoltaik nach dem Oberbegriff des Anspruchs 18.

Um fotovoltaische Zellen aus Silizium herstellen zu können, ist zunächst eine Phosphor-Dotierung der rohen Zellen erforderlich. Dazu wird die Zelle im ersten Schritt mit Phosphorsäure benetzt und die benetzten Zellen werden dann in einen Hochtemperaturofen bei ca. 800 bis 900 C° gebracht, wo aus der getrockneten Säure das Phosphor in das Siliziumsubstrat diffundiert. Dabei soll die Beschichtung zum einen sehr gleichmäßig erfolgen, um eine Gleichverteilung bei der Diffusion zu erreichen, und zum anderen sehr sparsam sein, da der Überschuss an Phosphorsäure auf die Zelle als "Phosphorglas" aufschmilzt und nur mühsam mit Hilfe von Flusssäure wieder abgetragen werden kann bzw. muss.

In bekannter Weise erfolgt das Aufbringen von Phosphorsäure auf die Siliziumsubstrate derart, dass mittels einer Hochfrequenzschallvorrichtung die Phosphorsäure vernebelt und der Phosphorsäurenebel auf die Siliziumsubstrate abgelegt wird. Der Phosphorsäurnebel wird dabei aus der Prozesskammer in einen Fallschacht geführt, der relativ breit ist und in relativ großem Abstand oberhalb der vorbeigeführten Siliziumsubstrate bzw. -zellen angeordnet ist. Nachteilig hieran ist, dass diese bekannte Einrichtung keine Gewähr für eine Homogenisierung des Nebels bietet, da schon leichte Luftbewegungen genügen, um den Nebel zu "verblasen". Außerdem führt die Ausgestaltung der Prozesskammer dazu, dass schädliche Kondensattropfen auf die Siliziumzellen fallen, was einer homogenen Benetzung bzw. Beschichtung entgegenläuft. Man hat versucht, derartige Kondensattropfen durch eine Tropfwanne unterhalb des Fallschachtes aufzufangen, was jedoch eine gleichmäßige Nebelausbreitung in noch größerem Maße behindert.

Das Dokument US 2003/039766 A1 offenbart eine Vorrichtung und ein Verfahren zum Auftragen von Flüssigkeitsschichten auf Substrate und zwar zum Aufbringen einer gleichmäßigen Flüssigkeitsschicht auf Substrate unter atmosphärischen Bedingungen. Die bekannte Vorrichtung umfasst in einer Ausführungsform eine atmosphärische Beschichtungsanlage mit einer Ultraschallsprühkammer, in der eine Ultraschallsprühdüse über dem Substrat positioniert wird und die Prozessflüssigkeit in einen feinen Flüssigkeitsnebel umwandelt. Diese Sprühdüse ist an einem Arm befestigt, der vom Rand zum Zentrum eines Wafers bewegt wird, oder umgekehrt. Das Substrat kann während des Beschichtungsvorganges optional rotiert werden. In Zusammenhang mit einem Transportband kann die Beschichtung mit der Vorrichtung und dem Verfahren auch in kontinuierlicher Form erfolgen.

Aufgabe der vorliegenden Erfindung ist es deshalb, eine Einrichtung zum Aufbringen einer gleichmäßigen, dünnen Flüssigkeits-, insbesondere Phosphorsäureschicht auf Substrate, insbesondere Siliziumzellen, für die Photovoltaik der eingangs genannten Art zu schaffen, die eine sowohl hinsichtlich der Fläche als auch der Menge wesentlich homogenere Aufbringung von Flüssigkeit, insbesondere Phosphorsäure auf die betreffenden Substrate, insbesondere Siliziumzellen zulässt.

Zur Lösung dieser Aufgabe sind bei einer Einrichtung zum Aufbringen einer gleichmäßigen, dünnen Flüssigkeitsinsbesondere Phosphorsäureschicht auf Substrate, insbesondere Siliziumzellen für die Fotovoltaik der genannten Art die im Anspruch 1 angegebenen Merkmale vorgesehen.

Durch die erfindungsgemäßen Maßnahmen ist innerhalb eines im wesentlichen geschlossenen Kreislaufes sowohl eine homogene Nebelbildung als auch eine homogene Führung des Flüssigkeitsnebels vom Erzeugungsort (Prozesskammer) bis zum Ort der Aufbringung und während der Aufbringung auf die Substrate, insbesondere Siliziumzellen erreicht. Diese

Homogenität betrifft sowohl die flächige Ablagerung als auch die mengenmäßige Ablagerung auf den Siliziumsubstraten. Außerdem lässt sich durch die Verjüngung des Flüssigkeitsnebel-Fallschachtes und dem sich ergebenden Rückstau eine Verdichtung und weitere Homogenisierung des Flüssigkeitsnebels erreichen.

Mit den Merkmalen nach Anspruch 2 ist eine herstellungstechnisch einfache Ausführung des Fallschachtes erreicht.

Mit den Merkmalen nach Anspruch 3 ist erreicht, dass die oberhalb der durchlaufenden Siliziumsubstrate angeordnete Decke der Durchlaufschachtanordnung auf Temperatur gehalten wird, so dass eine Kondensierung des Flüssigkeitsnebels und damit Tröpfchenbildung nicht möglich ist, was zusätzlich die Homogenität des Flüssigkeitsnebels und dessen Aufbringung fördert.

Mit den Merkmalen nach Anspruch 4 und/oder 5 ist eine regelbare und homogene aktive Durchleitung der Flüssigkeitsnebels vom Entstehungsort bis zur Aufbringung und während der Aufbringungsphase erreicht. Dabei ist es bei Einsatz des Abluftkanals zweckmäßig, die Merkmale nach Anspruch 6 vorzusehen, um die Homogenität des Flüssigkeitsnebels am Durchlaufende der Schachtanordnung nicht zu beeinträchtigen und dem Flüssigkeitsnebel eine definierte Strömungsgeschwindigkeit zu verleihen.

Mit den Merkmalen nach Anspruch 7 ist in bevorzugter und vorteilhafter Weise erreicht, dass sich durch die auf den Flüssigkeitsnebel wirkende Schwerkraft und Einwirkdauer über die Transportzeit hinweg der Flüssigkeitsnebel gleichmäßig und in ausreichender Menge auf den Siliziumsubstraten niederschlagen kann.

Nach den Merkmalen des Anspruchs 8 ist im Bereich der Flüssigkeitsnebelerzeugung ein Prallelement vorgesehen, das den Vorteil hat, dass dessen Kunststoffgewebe die Flüssigkeit spritzfrei auffängt und in die Flüssigkeitswanne zurückrieseln lässt. Eine vorteilhafte Ausgestaltung hierzu ergibt sich durch die Merkmale nach Anspruch 9.

Eine Ausgestaltung der Decke der Prozesskammer nach den Merkmalen des Anspruchs 10 ergibt im Hinblick auf die Homogenität des Flüssigkeitsnebels den Vorteil, dass sich durch die geneigte Anordnung das daran sammelnde Kondensat zurück in die Flüssigkeitswanne leiten lässt.

In entsprechender Weise werden gemäß Anspruch 11 Maßnahmen im Flüssigkeitsnebel Fallschacht vorgesehen, die in der Lage sind, Kondensat, das sich an den Wänden des Fallschachtes niederschlägt, tropffrei nach unten abzuleiten. Hierbei ist es zweckmäßig, die Merkmale nach Anspruch 12 vorzusehen, so dass das Kondensat über die Rinnen zur Seite abgeleitet werden kann.

Eine weitere bevorzugte konstruktive Ausgestaltung ergibt sich nach den Merkmalen des Anspruchs 13, mit dem Vorteil, dass eine derartige Einrichtung in der Breite eine nahezu beliebige Ausdehnung erhalten kann.

Bei der eingangs genannten bekannten Einrichtung wird eine Hochfrequenzschallvorrichtung eingesetzt, deren Hochfrequenzschallgeber, bzw. -erzeuger gegen Phosphorsäure nicht resistent ist. Deshalb ist es notwendig, ein Zwischenbehältnis einzusetzen, das luftfrei mit Wasser gefüllt und mit einem Temperierkreislauf verbunden ist. An der Unterseite des Zwischenbehältnisses ist der Hochfrequenzschallerzeuger befestigt, und an der Oberseite des Zwischenbehältnisses eine Membran, wobei das Wasser und die Membran als Schalltransmitter vom Hochfrequenzschallgeber zum darüber liegenden Phosphorsäurebecken bzw. -wanne dienen. Nachteilig hierbei ist die aufwendige teure Technik, häufige Ermüdungsbrüche der Membran und der daraus resultierende mühselige zeitaufwendige Austausch der Membran, als auch die Dämpfungseigenschaften eines solchen Schalltransmitters.

Um diese Nachteile zu vermeiden, sind bei einer Einrichtung der eingangs genannten Art die im Anspruch 14 angegebenen Merkmale vorgesehen. Auf diese weise ist erreicht, dass in der Quarzglasdüse sowohl die Phosphorsäure als auch der Schall fokussiert werden. Dabei ist es zweckmäßig, die Merkmale nach Anspruch 15 vorzusehen, so dass die in der Quarzglasdüse verdrängte Flüssigkeit über die Zuführungen nachfließen kann.

Eine bevorzugte konstruktive Ausgestaltung hierzu ergibt sich aus den Merkmalen nach Anspruch 16.

Mit den Merkmalen nach Anspruch 17 ist erreicht, dass der Hochfrequenzschallerzeuger im wesentlichen unmittelbar mit der Phosphorsäure in Verbindung gebracht werden kann, ohne dass sich Nachteile hinsichtlich in der Intensität der Hochfrequenzschallerzeugung ergeben.

Des Weiteren betrifft die vorliegende Erfindung ein Verfahren zum Aufbringen einer gleichmäßigen, dünnen Flüssigkeitsinsbesondere Phosphorsäureschicht auf Substrate, insbesondere Siliziumzellen für die Fotovoltaik: Wie erwähnt, mangelt es bei den bisherigen vergleichbaren Verfahren an der Homogenität der Flüssigkeitsnebelführung und damit der Phosphorsäureablagerung.

Um dies zu verbessern, sind bei einem Verfahren genannten Art die im Anspruch 18 angegebenen Merkmale vorgesehen. Mit den erfindungsgemäßen Maßnahmen ist erreicht, dass der Flüssigkeitsnebel sich aktiv und in homogener Weise von der Flüssigkeitsnebelerzeugung aus bis hin zum Aufbringen bzw. Niederschlagen der Flitssigkeitsnebelschicht auf die Substrate führen lässt.

Vorteilhafte Ausgestaltungen hierzu ergeben sich aus den Merkmalen des Anspruchs 19 und/oder 20.

Weitere Einzelheiten der Erfindung sind der folgenden Beschreibung zu entnehmen, in der die Erfindung anhand des in der Zeichnung dargestellten Ausführungsbeispieles näher beschrieben und erläutert ist.

Es zeigen:
- Figur 1: in schematischer teilweise längsgeschnittener Seitenansicht eine Einrichtung zum Aufbringen einer gleichmäßigen, dünnen Phosphorsäureschicht auf Siliziumsubstrate für die Fotovoltaik und
- Figur 2: eine bei der Einrichtung nach Figur 1 verwendete Hochfrequenzschallvorrichtung im eingebauten Zustand und im Querschnitt.

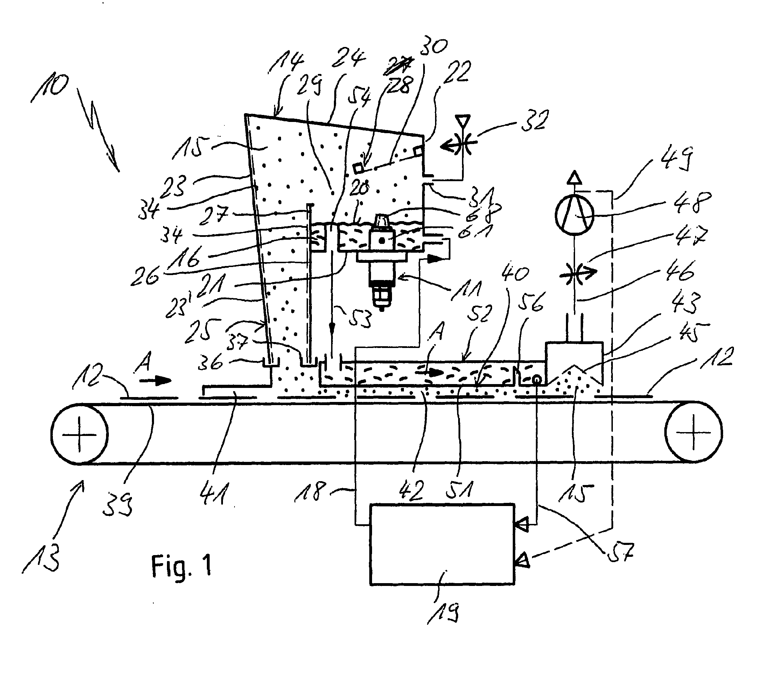

Die in Figur 1 dargestellte Einrichtung 10 dient zum Aufbringen einer gleichmäßigen, dünnen Phosphorsäureschicht auf Siliziumsubstrate bzw. -zellen 12 für die Fotovoltaik. Dabei werden die Siliziumsubstrate 12 auf einer Transportvorrichtung 13 in Richtung des Pfeiles A zugeführt und weggeführt und während der Transportbewegung mit einer Phosphorsäureschicht dadurch homogen, dass die Siliziumsubstrate 12 durch einen Phosphorsäurenebel 15, der mittels einer Hochfrequenzschallvorrichtung 11 innerhalb einer Prozesskammer 14 erzeugt wird, geführt werden.

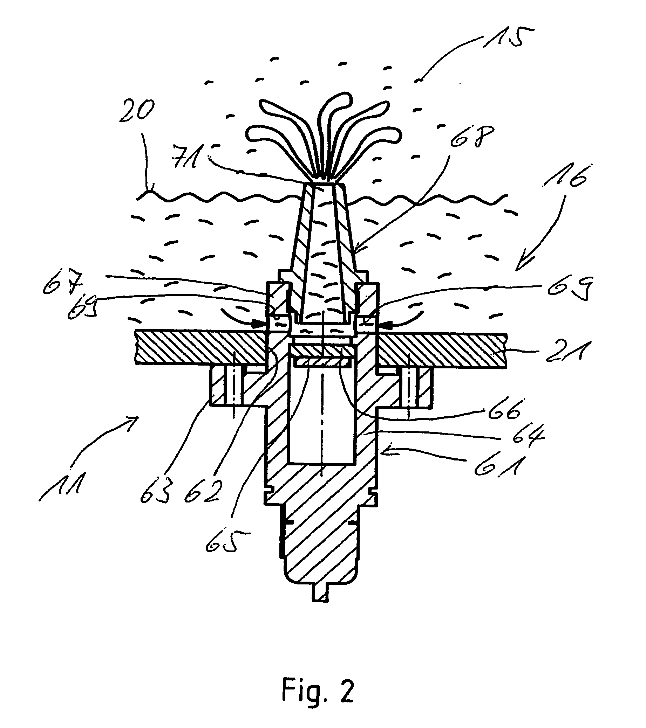

Gemäß Figur 1 ist in der sich in Richtung senkrecht zur Zeichnungsebene über eine gewählte Länge erstreckenden Prozesskammer 14 bodenseitig eine Wanne 16 angeordnet, die Phosphorsäure enthält. Die Phosphorsäurewanne 16 ist über eine Rohrleitung 18 mit einem Phosphorsäuretank 19 verbunden. Von diesem Tank 19 wird der Wanne 16 Phosphorsäure entsprechend dem Bedarf vorzugsweise temperiert. Im Boden 21 der Flüssigkeitswanne 16 ist die Hochfrequenzschallvorrichtung 11 befestigt, die weiter unten anhand der Figur 2 näher beschrieben wird.

Die Prozesskammer 14 ist von einer gemäß Figur 1 rechten Seitenwand 22, einer gegenüberliegenden linken Seitenwand 23, eine Decke 24 und parallel zur Zeichnungsebene liegenden und nicht dargestellten Endwänden begrenzt. Die Prozesskammer 14, die über dem Flüssigkeitstank 19 liegt, ist an ihrem der linken Seitenwand 23 zugewandten Bereich mit einem zur Transportvorrichtung 13 gerichteten Fallschacht 25 versehen. Die Decke 24 der Prozesskammer 14 ist von der rechten Seitenwand 23 ausgehend schräg ansteigend angeordnet und mit der linken Seitenwand 23 dicht verbunden, die in ihrer zur Transportvorrichtung 13 gerichteten Verlängerung 23' die Seitenwand des Fallschachtes 25 bildet. Diese Seitenwand 23, 23' ist zur Transportvorrichtung 13 hin schräg in Richtung zur rechten Seitenwand 22 geneigt, so dass sich ein etwa keilförmig zur Transportvorrichtung 13 hin gestalteter bzw. verjüngender Fallschacht 25 ergibt, dessen gegenüberliegende Seitenwand 26 sich vertikal und damit parallel zur höher liegenden rechten Seitenwand 22 der Prozesskammer 14 erstreckt. Diese Seitenwand 26 des Fallschachtes 25 begrenzt die Flüssigkeitswanne 16 und ist über den Flüssigkeitsspiegel 20 der Flüssigkeitswanne 16 hinaus unter Bildung eines Wehres 27 verlängert.

Im oberen Bereich der rechten Seitenwand 22 der Prozesskammer 14 ist ein Prallelement 27 befestigt, das schräg nach unten, d.h. zur Flüssigkeitswanne 16 hin geneigt in die Prozesskammer 14 ragt und in einem Abstand vor dem Wehr 27 unter Bildung eines Durchganges 29 endet.

Das Prallelement 28 besitzt einen mit Kunststoffgewebe 30 bespannten Rahmen, wobei das Kunststoffgewebe 30 die mittels der Hochfrequenzschallvorrichtung 11 herausgeschleuderte Phosphorsäuretröpfchen im Phosphorsäurenebel 15 spritzfrei auffängt und die Tröpfchen in die Flüssigkeitswanne 16 zurückrieseln lässt. Es tritt somit lediglich der, Phosphorsäurenebel durch den Durchgang 29 und das Kunststoffgewebe 30 des Prallelements 28 hindurch den dahinter liegenden Raum der Prozesskammer 14. Das Kunststoffgewebe 30 des Prallelements 28 lässt außerdem das sich an der Decke 24 der Prozesskammer 14 sammelnde und zur rechten Seitenwand 22 zurückfließende Kondensat durch und in die Flüssigkeitswanne 16 abfließen.

In einem Bereich zwischen dem Flüssigkeitsspiegel 20 der Wanne 16 und dem Prallelement 28 ist ein Zuluftanschluss 31 vorgesehen, dessen Zuführleitung mit einer Regeleinrichtung 32 versehen ist. Damit wird über die regelbare Zuluft 31, 32 der entstandene Phosphornebel über das Wehr 27 zum Eingang des Fallschachtes 25 getrieben bzw. aktiv bewegt.

Sowohl die ineinander übergehenden Teile der linken Seitenwand 23, 23' als auch die Seitenwand 26 des Fallschachtes 25 sind mit einer Gewebebespannung 34 versehen, um zu erreichen, dass sich das Kondensat des Phosphorsäurenebels 15, das sich an den Wänden des Fallschachtes 25 niederschlägt, von dieser Gewebebespannung 34 tropffrei nach unten abgeleitet werden kann. Hierzu enden die Unterkanten der Seitenwände 23, 23' und 26 oberhalb von Rinnen 36 bzw. 37, die das Kondensat in nicht im einzelnen dargestellter Weise zur Seite, d.h. in einer Richtung senkrecht zur Zeichnungsebene ableiten.

Über der Transportvorrichtung 13 bzw. dem oberen Trumm 39 der Transportvorrichtung 13, auf dem die Siliziumsubstrate 12 aufliegen und in Richtung des Pfeiles A bewegt werden, ist eine Durchlauf-Schachtanordnung 40 vorgesehen, die einen Einlaufbereich 41 vor dem Fallschacht 25 und einen Auslaufbereich 42 nach dem Fallschacht 25 besitzt. Zwischen dem Einlaufbereich 41 und dem Auslaufbereich 42 ist die Schachtanordnung 40 nach oben offen, in welchen Öffnungsbereich der Fallschacht 25 mündet. Am in Durchlaufrichtung A hinteren Ende ist der Auslaufbereich 42 der Schachtanordnung 40 mit einem Absaugkasten 43 versehen, in dessen Öffnung, die dem Trumm 39 der Transportvorrichtung 13 zugewandt ist, ein dachförmig angeordnetes Kunststoffgewebe 45 zur Bildung eines Laminarisators angeordnet. Am diesem Kunststoffgewebe 45 abgewandten Ende des Absaugkastens 43 ist eine Absaugleitung 46 befestigt, in der eine Regelvorrichtung 47 mit einem Sauggebläse 48 zur aktiven Bewegung bzw. Strömung des Phosphorsäurenebels 15 angeordnet sind. Hinter dem Sauggebläse 48 ist eine Kondensatrückführung 49 vorgesehen, die in den Phosphorsäuretank 19 mündet.

Aufgrund der beiden Regeleinrichtungen 32 und 47 für die Zuluft und Abluft kann der entstandene Phosphorsäurenebel 15 in regelbarer Weise von dem Ort der Entstehung, nämlich der Prozesskammer 14, über den nach unterhalb der Prozesskammer 14 und der Flüssigkeitswanne 16 ragenden Fallschacht 25 in die Schachtanordnung 40 zu dem Ort bewegt werden, an dem die Siliziumsubstrate 12 beschichtet werden. Aufgrund der keilförmigen Ausgestaltung des Fallschachtes 25 wird durch den Rückstau der Phosphorsäurenebel verdichtet und homogenisiert. Durch den unmittelbaren Übergang vom Fallschacht 25 in die relativ niedrige Schachtanordnung 40 bleibt der Phosphornebel 15 homogen und verdichtet und füllt somit den Auslaufbereich 42 der Schachtanordnung 40 komplett bzw. vollständig aus. Da mit Hilfe des Absaugkastens 43 der nicht abgelagerte Teil des Phosphorsäurenebels 15 aus dem Auslaufbereich 42 der Schachtanordnung 40 über dessen gesamte Breite gleichmäßig abgesaugt wird, bleibt die Homogenität des Phosphorsäurenebels im Auslaufbereich 42 erhalten. Damit kann sich aufgrund der auf den Phosphorsäurenebel wirkenden Schwerkraft und der Einwirkdauer über die Transportzeit hinweg Phosphorsäure gleichmäßig und in ausreichender Menge auf die Substrate 12 niederschlagen. Die Dosierung des Phosphorsäurenebels erfolgt feinfühlig über die Zu- und Abluftregelung sowie über die Leistungsregelung der Hochfrequenzschallvorrichtung 11. Ein homogenes und gleichmäßiges (örtliches und zeitliches) Einwirken des Phosphorsäurenebels auf die Siliziumsubstrate 12 wird außerdem dadurch erreicht, dass die Transportgeschwindigkeit der Transportvorrichtung 13 für die Siliziumsubstrate 12 an die Geschwindigkeit der Bewegung des Phosphorsäurenebels 15 durch den weitgehend geschlossenen Kreislauf von der Prozesskammer 14 über den Fallschacht 25 und die Schachtanordnung 40 bis zum Absaugkasten 43 angepasst und vorzugsweise mit ihr synchronisiert, d.h., gleichgesetzt wird.

Für eine gleichmäßig homogene Führung des Phosphorsäurenebels 15 über die gesamte Strecke ist es von Bedeutung, dass die Dimensionierung bzw. das Mündungsende des vertikalen Flüssigkeitsnebel-Fallschachtes 25 und der den Ablagerungsraum abgrenzenden Durchlauf-Schachtanordnung 40 für die Substrate 12 aufeinander abgestimmt, vorzugsweise identisch sind.

Um innerhalb des Auslaufbereichs 42 der Schachtanordnung 40 ein Kondensieren des Phosphorsäurenebels (15) an der Decke 51 der Schachtanordnung 40 zu vermeiden, ist über dem Auslaufbereich 42 ein Rücklaufschacht 52 vorgesehen, dessen Boden durch die Decke 51 gebildet ist. Der Rücklaufschacht 52 ist über eine Leitung 53 mit einem Füllstandsrohr 54 der Phosphorsäurewanne 16 in einem Bereich des Zugangsendes des Auslaufbereichs 42 der Schachtanordnung 40 verbunden, so dass temperierte und aus der Wanne 16 überlaufende Phosphorsäure über der Schachtanordnung 40 in Richtung der Transportrichtung A strömen kann. Am Ende des Rücklaufschachtes 52 ist hinter einem wehrähnlichen Element 56 eine Rohrleitung 57 angeschlossen, die die überschüssige Phosphorsäure in den Phosporsäuretank 19 zurückführt.

Figur 2 zeigt in einem Ausschnitt der Figur 1 die bei der Einrichtung 10 verwendete Hochfrequenzschallvorrichtung 11 in schematischer längsgeschnittener Darstellung. Die Hochfrequenzschallvorrichtung 11 besitzt ein Kunststoffgehäuse 61, das eine Bohrung 62 im Boden 21 der Phosphorsäurewanne durchdringt und mit einem Flansch 63 an der Unterseite des Wannenbodens 21 befestigt ist. Innerhalb eines vom Flansch 63 umgebenen unteren hohlen Gehäuseteils 64 ist im Bereich des Wannenbodens 21 als Hochfrequenzschallerzeuger ein Piezoelement 65 angeordnet, dessen Unterseite in nicht dargestellter Weise mit Verbindungsleitungen versehen ist und dessen Oberseite mit einer Quarzglasscheibe 66 belegt vorzugsweise verklebt ist. Die Quarzglasscheibe 66 ist in ihrer Dicke auf die Hochfrequenzschallfrequenz des Piezoelementes 65 abgestimmt, so dass der Schall nahezu verlustfrei durchgeleitet werden kann. Diese Einheit aus Piezoelement 65 und Quarzglasscheibe 66 ist mit der letzteren voraus an der der Phosphorsäure in der Wanne 16 zugewandten Seite hermetisch dicht zur Unterseite hin in dem hohlen Gehäuseteil 64 eingebaut. In das in die Phosphorsäurewanne 16 ragende und mit dem hohlen Gehäuseteil 64 einstückige obere hohle Gehäuseteil 67 ist eine Quarzglasdüse 68 mit ihrem unteren durchmessergrößeren Ende eingeschraubt. In das obere hohle Gehäuseteil 67 sind eine Vielzahl von über dem Umfang angeordnete radiale Bohrung 69 eingebracht, über die die in der Wanne 16 enthaltene Phosphorsäure in den Raum der Quarzglasdüse 68 zufließen kann und auch mit der Quarzglasscheibe 66 in Berührung kommt. Die Quarzglasdüse 68 verjüngt sich zu ihrer in die Prozesskammer 14 ragenden Mündung 71 hin. Damit ragt die mit der Mündung 71 versehene Spitze der Quarzglasdüse 68 über den Flüssigkeitsspiegel 20 der Phosphorsäure in der Wanne 16 ein stückweit hinaus. In der Quarzglasdüse 68 werden sowohl die Phosphorsäure als auch der Schall fokussiert, wenn durch Hochfrequenzschallenergie des Piezoelementes 65 über die Scheibe 66 die in der Düse 68 enthaltene Phosphorsäure über den Flüssigkeitsspiegel 20 der Phosphorsäure in der Wanne 16 hinaus hochgeschleudert wird. Um die herausgeschleuderte Phosphorsäure herum ergibt sich eine heftige Bildung von Phosphorsäurenebel 15. Wie erwähnt, werden die Phosphorsäuretröpfchen, die sich vom Phosphorsäurenebel am Prallelement separieren, von der Wanne 16 wieder aufgefangen.

Die in der Quarzglasdüse 68 verdrängte Phosphorsäure zur Bildung des Phosphorsäurenebels 15 kann über die radialen Bohrungen 69 aus der Wanne 16 wieder nachfließen.

Es sei angemerkt, dass die in Figur 1 dargestellte Einrichtung 10 statt mit der Hochfrequenzschallvorrichtung 11 nach Figur 2 auch mit einer in anderer Weise ausgebildeten Hochfrequenzschallvorrichtung versehen sein kann.

## Patentansprüche

1. Einrichtung (10) zum Aufbringen einer gleichmäßigen dünnen Flüssigkeits-, insbesondere Phosphorsäureschicht auf Substrate (12), insbesondere Siliziumzellen für die Fotovoltaik, mit einer Prozesskammer (14), die mit einer Flüssigkeitswanne (16) und einer die Flüssigkeit in Flüssigkeitsnebel (15) umwandelnde Hochfrequenzschallvorrichtung (11) versehen ist, und mit einer unterhalb eines Flüssigkeitsnebel-Fallschachtes (25) der Prozesskammer (14) angeordneten Transportvorrichtung (13) für die Substrate (12), **dadurch gekennzeichnet, dass** der Flüssigkeitsnebel-Fallschacht (25) der Prozesskammer (14) zur Transportvorrichtung (13) hin eine Verjüngung seines lichten Querschnitts erfährt und in eine die Transportvorrichtung (13) überdeckende Durchlauf-Schachtanordnung (40) für die Substrate (12) mündet, und dass die lichten Querschnitte des Mündungsendes des Flüssigkeitsnebel-Fallschachtes (25) und der Durchlauf-Schachtanordnung (40) aufeinander abgestimmt, vorzugsweise im Wesentlichen gleich sind.

2. Einrichtung nach Anspruch 1, **dadurch gekennzeichnet, dass** der Flüssigkeitsnebel-Fallschacht (25) zum Durchlauf-Schachtanordnung (40) hin keilförmig ausgebildet ist.

3. Einrichtung nach Anspruch 1 oder 2, **dadurch gekennzeichnet, dass** auf der Durchlauf-Schachtanordnung (40) in Durchlaufrichtung (A) nach der Mündung des Fallschachtes (25) ein mit der Flüssigkeitswanne (16) verbundener Rücklaufschacht (52) angeordnet ist, dessen der Mündung abgewandtes hinteres Ende mit einem Flüssigkeitstank (19) verbunden ist.

4. Einrichtung nach mindestens einem der Ansprüche 1 bis 3, **dadurch gekennzeichnet, dass** in einem Bereich oberhalb der Hochfrequenzschallvorrichtung (11) ein mit einer ersten Regelvorrichtung (32) verbundenes Zuluftrohr (31) mündet.

5. Einrichtung nach mindestens einem der vorhergehenden Ansprüche, **dadurch gekennzeichnet, dass** am Ende der Durchlaufschacht-Anordndung (40) ein mit einer zweiten Regelvorrichtung (47) versehener Abluftkanal (46) vorgesehen ist.

6. Einrichtung nach Anspruch 5, **dadurch gekennzeichnet, dass** zwischen der Durchlauf-Schachtanordnung (40) und dem Abluftkanal (46) ein mit einem Laminarisator (45) versehener Absaugkasten (43) angeordnet ist, der mit einem Sauglüfter (48) verbunden ist.

7. Einrichtung nach mindestens einem der vorhergehenden Ansprüche, **dadurch gekennzeichnet, dass** die erste und die zweite Regelvorrichtung (32, 47) für die Geschwindigkeit des Nebeltransports von der Prozesskammer (14) durch die Durchlaufschachtanordnung (40) und die Geschwindigkeit der Transportvorrichtung (13) für die Substrate (12) aufeinander abstimmbar, vorzugsweise synchronisierbar sind.

8. Einrichtung nach mindestens einem der vorhergehenden Ansprüche, **dadurch gekennzeichnet, dass** in der Prozesskammer (14) oberhalb der Hochfrequenzschallvorrichtung (11) bzw. der Flüssigkeitswanne (16) eine ein Gewebe (30), vorzugsweise Kunststoffgewebe, aufweisendes Prallelement (28) vorgesehen ist.

9. Einrichtung nach Anspruch 8, **dadurch gekennzeichnet, dass** zwischen dem freien Ende des von einer dem Fallschacht (25) abgewandten Prozesskammerwand (22)
ausgehenden geneigten Prallelementes (28) und einem an dem dieser Prozesskammerwand (22) abgewandten Ende der Flüssigkeitswanne (16) angeordneten Wehr (27) ein Durchgang (29) für den Flüssigkeitsnebel vorgesehen ist.

10. Einrichtung nach mindestens einem der vorhergehenden Ansprüche, **dadurch gekennzeichnet, dass** die Decke (24) der Prozesskammer (14) von der einen dem Fallschacht (25) abgewandten Prozesskammerwand (22) ausgehend ansteigend geneigt ist.

11. Einrichtung nach mindestens einem der vorhergehenden Ansprüche, **dadurch gekennzeichnet, das** der keilförmige Flüssigkeitsnebel-Fallschacht (25) an seinen Begrenzungswänden (23, 26) mit einer Gewebebespannung (34) versehen ist.

12. Einrichtung nach Anspruch 11, **dadurch gekennzeichnet, dass** die Begrenzungswände (23, 26) des Fallschachtes (25) im Mündungsbereich der Durchlauf-Schachtanordnung (40) über Ablaufrinnen (36, 37) enden.

13. Einrichtung nach mindestens einem der vorhergehenden Ansprüche, **dadurch gekennzeichnet, dass** entsprechend einer quer zur Durchlaufrichtung (A) vorgesehenen Breite der Transportvorrichtung (13) und damit der Prozesskammer (14) eine Mehrzahl von in diese Richtung in vorgegebenem Abstand angeordnete Hochfrequenzschallvorrichtungen (11) vorgesehen ist.

14. Einrichtung (10) dünnen Flüssigke nach Anspruch 1 oder einem der Vorhergehenden Ansprüche, **dadurch gekennzeichnet, dass** die Hochfrequenzschallvorrichtung (11) zum Vernebeln der Flüssigkeit mit einer Düse (68), vorzugsweise aus Quarzglas, versehen ist, unterhalb der ein Hochfrequenzschallerzeuger (65) angeordnet ist.

15. Einrichtung nach Anspruch 14, **dadurch gekennzeichnet, dass** zwischen der aus dem Flüssigkeitsspiegel (20) in der Flüssigkeitswanne (16) ragenden Düse (68) und dem Hochfrequenzschallerzeuger (65) Zuführungen (69) für die Flüssigkeit aus der Wanne (16) in die Düse (68) vorgesehen sind.

16. Einrichtung nach Anspruch 14 oder 15, **dadurch gekennzeichnet, dass** die Düse (68) in einem Gehäuse (61) vorzugsweise aus Kunststoff gehalten ist, das im Boden (21) der Flüssigkeitswanne (16) befestigt ist und diesen flüssigkeitsdicht durchdringt, dass im Bereich des Wannenbodens (21) der Hochfrequenzschallerzeuger (65) im Gehäuse (61) befestigt ist und dass in dem innerhalb der Flüssigkeitswanne (16) befindlichen Teil (67) des Gehäuses (61) eine Vielzahl radialer Zuführbohrungen (69) vorgesehen ist.

17. Einrichtung nach mindestens einem der Ansprüche 14 bis 16, **dadurch gekennzeichnet, dass** der Hochfrequenzschallerzeuger ein Piezoelement (65) ist, auf dem der Düse (68) zugewandt ein auf die Schallfrequenz abgestimmtes Quarzglasplättchen (66) befestigt, vorzugsweise geklebt ist.

18. Verfahren zum Aufbringen einer gleichmäßigen, dünnen Flüssigkeits-, insbesondere Phosphorsäureschicht auf Substrate, insbesondere Siliziumzellen für die Fotovoltaik, bei dem innerhalb einer Prozesskammer mittels einer Hochfrequenzschallvorrichtung ein Flüssigkeitsnebel erzeugt wird, der auf die vorzugsweise mittels einer Transportvorrichtung bewegte Substrate fällt bzw. abgelagert wird, **dadurch gekennzeichnet, dass** der Flüssigkeitsnebel aus der Prozesskammer auf seinem Weg zu den Substraten aktiv bewegt wird und dass der Flüssigkeitsnebel in einem an die Prozesskammer anschließenden Fallschacht verdichtet und homogenisiert wird und von dort in eine über den bewegten Substraten angeordnete Durchlauf-Schachtanordnung geführt und auf den Substraten abgelagert, wobei die aktive Bewegung des Flüssigkeitsnebels mit der Geschwindigkeit der Substrate abgestimmt, vorzugsweise synchronisiert wird.

19. Verfahren nach Anspruch 18, **dadurch gekennzeichnet, dass** unmittelbar auf der den abzulagernden Flüssigkeitsnebel führenden Durchlauf-Schachtanordnung erwärmte Flüssigkeit rückgeführt wird.

20. Verfahren nach Anspruch 18 oder 19, **dadurch gekennzeichnet, dass** der Flüssigkeitsnebel am Ende der Durchlauf-Schachtanordnung als Rest gleichmäßig abgesaugt wird.

## Claims

1. A device (10) for applying an even, thin fluid layer, in particular a phosphoric acid layer, onto substrates (12), in particular silicon cells for photovoltaic application, having a process chamber (14), which is provided with a fluid pan (16) and a high-frequency ultrasound device (11) that converts the fluid into fluid mist (15), and having a transport device (13) that is arranged beneath a fluid-mist dropping shaft (25) of the process chamber (14) for the substrates (12), wherein the fluid-mist dropping shaft (25) of the process chamber (14) tapers in its interior cross-section towards the transport device (13) and discharges into a passage shaft arrangement (40) for the substrates (12) that covers the transport device (13), and the interior cross-section of the orifice end of the fluid-mist dropping shaft (25) and of the passage shaft arrangement (40) are coordinated with each other, preferably being essentially identical.

2. The device as recited in Claim 1, wherein the fluid-mist dropping shaft (25) is wedge-shaped in the direction of the passage shaft arrangement (40).

3. The device as recited in Claim 1 or 2, wherein on the passage shaft arrangement (40) in the passage direction (A) downstream of the orifice of the dropping shaft (25) a return shaft (52) is arranged that is connected to the fluid pan (16), the rear end of the return shaft that faces away from the orifice being connected to a fluid tank (19).

4. The device as recited in at least one of Claims 1 to 3, wherein in an area above the high-frequency ultrasound device (11) an air supply pipe (31) discharges that is connected to a first regulating device (32).

5. The device as recited in at least one of the preceding claims, wherein at the end of the passage shaft arrangement (40) an air discharge channel (46) is provided that is connected to a second regulating device (47).

6. The device as recited in Claim 5, wherein between the passage shaft arrangement (40) and the air discharge channel (46) an extractor box (43) is arranged that is provided with a laminar flow box (45) that is connected to a suction fan (48).

7. The device as recited in at least one of the preceding claims, wherein the first and the second regulating device (32, 47) can be coordinated with each other, preferably synchronized, for the velocity of the mist as it moves from the process chamber (14) through the passage shaft arrangement (40) and the velocity of the transport device (13) for the substrates (12).

8. The device as recited in at least one of the preceding claims, wherein an impact element (28) that has a web (30), preferably a plastic web, is provided within the process chamber (14) above the high-frequency ultrasound device (11) and the fluid pan (16).

9. The device as recited in Claim 8, wherein a passage (29) for the fluid mist is provided between the free end of the tilted impact element (28), which emerges from a process chamber wall (22) that faces away from the dropping shaft (25) and a dam (27) that is arranged on the end of the fluid pan (16) that faces away from this process chamber wall (22),.

10. The device as recited in at least one of the preceding claims, wherein the cover (24) of the process chamber (14) is tilted at a rising slope as it emerges from the process chamber wall (22) that faces away from the dropping shaft (25).

11. The device as recited in at least one of the preceding claims, wherein the wedge-shaped fluid-mist dropping shaft (25) on its bordering walls (23, 26) is furnished with a web covering (34).

12. The device as recited in Claim 11, wherein the bordering walls (23, 26) of the dropping shaft (25) terminate in the orifice area of the passage shaft arrangement (40) via runoff channels (36, 37).

13. The device as recited in at least one of the preceding claims, wherein in accordance with a width of the transport device (13) transverse to the passage direction (A) and therefore of the process chamber (14), a multiplicity of high-frequency ultrasound devices (11) are provided at pre-established intervals in this direction.

14. The device (10) as recited in Claim 1 or in any of the preceding claims, wherein the high-frequency ultrasound device (11) for atomizing the fluid is provided with a nozzle (68), preferably made of quartz glass, beneath which a high-frequency ultrasound generator (65) is arranged.

15. The device as recited in Claim 14, wherein supply lines (69) are provided between the nozzle (68) that protrudes from the fluid surface (20) in the fluid pan (16) and a high-frequency ultrasound generator (65) to allow the fluid to flow from the pan (16) into the nozzle (68).

16. The device as recited in Claim 14 or 15, wherein the nozzle (68) is held in a housing (61), preferably made of plastic, which is secured on the base (21) of the fluid pan (16) and penetrates this base in a fluid-tight manner, the high-frequency ultrasound generator (65) is attached in the housing (61) in the area of the pan base (21), and a multitude of radial supply boreholes (69) are provided in the part (67) of the housing (61) that is located within the fluid pan (16).

17. The device as recited in at least one of Claims 14 to 16, wherein the high-frequency ultrasound generator is a piezoelectric element (65), on which a quartz glass plate (66) is attached, preferably glued, which faces the nozzle (68) and is coordinated with the ultrasound frequency.

18. A method for applying an even, thin fluid layer, in particular a phosphoric acid layer, onto substrates, in particular silicon cells for photovoltaic application, in which, within a process chamber, a high-frequency ultrasound device generates a fluid mist which settles, i.e., is deposited, on substrates that are preferably moved by a transport device, wherein the fluid mist is actively moved out of the process chamber on its way to the substrates, is compressed and homogenized in a dropping shaft that is connected to the process chamber, from there is conveyed into a passage shaft arrangement that is arranged over the moving substrates, and is deposited upon the substrates, whereby the active process of moving the fluid mist is coordinated with the velocity of the substrates, preferably being synchronized therewith.

19. The method as recited in Claim 18, wherein fluid is directly returned that has been heated on the passage shaft arrangement that conveys the fluid mist to be deposited.

20. The method as recited in Claim 18 or 19, wherein the fluid mist is evenly suctioned off as residue at the end of the passage shaft arrangement.

## Revendications

1. Dispositif (10) pour l'application d'une mince couche de liquide homogène, en particulier une couche d'acide phosphorique, sur des substrats (12), en particulier des cellules de silicium pour le photovoltaïque, comportant une chambre opératoire (14), qui est munie d'une cuve de liquide (16) et d'un dispositif sonique à haute fréquence (11) transformant le liquide en nuage de liquide (15), et comportant un dispositif de transport (13) pour les substrats (12), disposé en dessous d'une gaine verticale pour nuage de liquide (25) de la chambre opératoire (14), **caractérisé en ce que** la gaine verticale pour nuage de liquide (25) de la chambre opératoire (14) présente un rétrécissement de sa section libre en direction du dispositif de transport (13) et débouche dans une gaine de passage (40) pour les substrats (12), couvrant le dispositif de transport (13), et **en ce que** les sections libres de la bouche de la gaine verticale pour nuage de liquide (25) et de la gaine de passage (40) sont ajustées entre elles, de préférence sont sensiblement identiques.

2. Dispositif selon la revendication 1, **caractérisé en ce que** la gaine verticale pour nuage de liquide (25) est réalisée en forme de cône en direction de la gaine de passage (40).

3. Dispositif selon la revendication 1 ou 2, **caractérisé en ce que** sur la gaine de passage (40), dans la direction de passage (A), en aval de la bouche de la gaine verticale (25) est agencée une gaine de renvoi (52), qui est reliée à la cuve de liquide (16) et dont l'extrémité arrière, détournée de la bouche, est reliée à un réservoir de liquide (19).

4. Dispositif selon au moins l'une des revendications 1 à 3, **caractérisé en ce que** dans une zone au-dessus du dispositif sonique à haute fréquence (11) débouche un tube d'air frais (31) relié à un premier dispositif de réglage (32).

5. Dispositif selon au moins l'une des revendications précédentes, **caractérisé en ce qu'**à l'extrémité de la gaine de passage (40) est prévu un conduit d'air vicié (46) muni d'un deuxième dispositif de réglage (47).

6. Dispositif selon la revendication 5, **caractérisé en ce qu'**entre la gaine de passage (40) et le conduit d'air vicié (46) est disposé un caisson d'aspiration (43), qui est muni d'un laminarisateur (45) et qui est relié à un ventilateur d'aspiration (48).

7. Dispositif selon au moins l'une des revendications précédentes, **caractérisé en ce que** le premier et le deuxième dispositif de réglage (32, 47) pour la vitesse de transport du nuage depuis la chambre opératoire (14) à travers la gaine de passage (40) et la vitesse du dispositif de transport (13) pour les substrats (12) peuvent être ajustés entre eux, de préférence peuvent être synchronisés.

8. Dispositif selon au moins l'une des revendications précédentes, **caractérisé en ce que** dans la chambre opératoire (14), au-dessus du dispositif sonique à haute fréquence (11) ou de la cuve de liquide (16), il est prévu un élément de rebondissement (28) comportant un textile (30), de préférence un textile en matière plastique.

9. Dispositif selon la revendication 8, **caractérisé en ce qu'**entre l'extrémité libre de l'élément de rebondissement (28) incliné à partir d'une paroi (22) de la chambre opératoire, détournée de la gaine verticale (25), et un barrage (27), disposé au niveau de l'extrémité, opposée à ladite paroi (22), de la cuve de liquide (16), il est prévu un passage (29) pour le nuage de liquide.

10. Dispositif selon au moins l'une des revendications précédentes, **caractérisé en ce que** la paroi supérieure (24) de la chambre opératoire (14) est inclinée en pente ascendante à partir de la paroi (22) de la chambre opératoire, opposée la gaine verticale (25).

11. Dispositif selon au moins l'une des revendications précédentes, **caractérisé en ce que** la gaine verticale pour nuage de liquide (25) en forme de cône est munie d'un parement textile (34) sur ses parois (23, 26).

12. Dispositif selon la revendication 11, **caractérisé en ce que** les parois (23, 26) de la gaine verticale (25) se terminent par des goulottes de déversement (36, 37) dans la zone de la bouche de la gaine de passage (40).

13. Dispositif selon au moins l'une des revendications précédentes, **caractérisé en ce que**, conformément à une largeur, prévue transversalement à la direction de passage (A), du dispositif de transport (13) et donc de la chambre opératoire (14), il est prévu une pluralité de dispositifs soniques à haute fréquence (11) disposés à distance les uns des autres dans cette direction.

14. Dispositif (10) selon la revendication 1 ou l'une des revendications précédentes, **caractérisé en ce que** le dispositif sonique à haute fréquence (11) destiné à transformer le liquide en nuage, est muni d'une buse (68), de préférence en verre de quartz, en dessous de laquelle est disposé un générateur de son à haute fréquence (65).

15. Dispositif selon la revendication 14, **caractérisé en ce qu'**entre la buse (68), sortant du niveau de liquide (20) dans la cuve de liquide (16), et le générateur de son à haute fréquence (65), il est prévu des admissions (69) pour le liquide sortant de la cuve (16) et entrant dans la buse (68).

16. Dispositif selon la revendication 14 ou 15, **caractérisé en ce que** la buse (68) est logée dans un boîtier (61), de préférence en matière plastique, qui est fixé dans le fond (21) de la cuve de liquide (16) et traverse celui-ci de manière étanche au liquide, **en ce que** le générateur de son à haute fréquence (65) est fixé dans le boîtier (61) dans la zone du fond (21) de la cuve, et **en ce qu'**une pluralité de forures d'admission (69) radiales sont prévues dans la partie (67) du boîtier (61), située à l'intérieur de la cuve de liquide (16).

17. Dispositif selon au moins l'une des revendications 14 à 16, **caractérisé en ce que** le générateur de son à haute fréquence (65) est un élément piézoélectrique (65), sur lequel est fixé, de préférence collé, une plaquette en verre de quartz (66), orientée vers la buse (68) et ajustée à la fréquence sonore.

18. Procédé pour l'application d'une mince couche de liquide homogène, en particulier une couche d'acide phosphorique, sur des substrats, en particulier des cellules de silicium pour le photovoltaïque, dans lequel un nuage de liquide est généré au moyen d'un dispositif sonique à haute fréquence à l'intérieur d'une chambre opératoire, lequel nuage de liquide tombe et est déposé sur les substrats déplacés de préférence au moyen d'un dispositif de transport, **caractérisé en ce que** le nuage de liquide sortant de la chambre opératoire est déplacé activement sur son trajet vers les substrats et **en ce que** le nuage de liquide est comprimé et homogénéisé dans une gaine verticale adjacente à la chambre opératoire et, à partir de là, est transporté dans une gaine de passage, disposée au-dessus des substrats en mouvement, et est déposé sur les substrats, le mouvement actif du nuage de liquide étant ajusté, de préférence synchronisé, à la vitesse des substrats.

19. Procédé selon la revendication 18, **caractérisé en ce que** directement sur la gaine de passage guidant le nuage de liquide à déposer, le liquide chauffé est renvoyé.

20. Procédé selon la revendication 18 ou 19, **caractérisé en ce que** le nuage de liquide est aspiré de manière homogène comme reste au niveau de l'extrémité de la gaine de passage.
